# EUROPEAN PATENT SPECIFICATION

(11) **EP 2 564 954 B1**
(45) Date of publication and mention of the grant of the patent: **19.07.2017**
(21) Application number: 12181186.3
(22) Date of filing: 21.08.2012
(51) Int. Cl.: B22F 1/00, B22F 9/24, B01J 13/00, C09D 11/02, B82Y 30/00, C09D 11/322, C09D 11/52, H05K 1/09

(54) **Collagen peptide-coated copper nanoparticles, collagen peptide-coated copper nanoparticle dispersion, method for preparing collagen peptide-coated copper nanoparticles, conductive ink, method for preparing conductive film**
Kollagen-peptidbeschichtete Kupfernanopartikel, kollagen-peptidbeschichtete Kupfernanopartikeldispersion, Verfahren zur Herstellung von kollagen-peptidbeschichtete Kupfernanopartikeln, leitfähige Tinte, Verfahren zur Herstellung eines leitfähigen Films
Nanoparticules de cuivre enrobées de peptide de collagène, dispersion de nanoparticules de cuivre enrobées de peptide de collagène, procédé de préparation de nanoparticules de cuivre enrobées de peptide de collagène, de l'encre conductrice, procédé de préparation de film conducteur

(30) Priority: 30.08.2011 JP 2011188047; 02.07.2012 JP 2012148536
(43) Date of publication of application: 06.03.2013
(73) Proprietor: Fujifilm Corporation, Minato-ku Tokyo 106-8620 (JP)
(72) Inventor: Kato, Takahiro, Kanagawa, 258-8577 (JP)
(74) Representative: Hoffmann Eitle

(56) References cited:
- EP-A1- 2 319 643
- TOMONARI M ET AL: "Size-controlled oxidation-resistant copper fine particles covered by biopolymer nanoskin", JOURNAL OF NANOSCIENCE AND NANOTECHNOLOGY AMERICAN SCIENTIFIC PUBLISHERS USA, vol. 8, no. 5, May 2008 (2008-05), pages 2468-2471, XP8158323, ISSN: 1533-4880

## Description

### BACKGROUND OF THE INVENTION

### 1. Field of the Invention

The present invention relates to copper nanoparticles having an average particle diameter of 50 nm or less, the surface of which is coated with collagen peptides having a weight average molecular weight of 10000 or less; a collagen peptide-coated copper nanoparticle dispersion formed by dispersing the particles in a medium; and a method for preparing collagen peptide-coated copper nanoparticles. The present invention further relates to a conductive ink using the collagen peptide-coated copper nanoparticles; and a method for preparing a conductive film, using the conductive ink.

### 2. Description of the Related Art

In the related art, fine metal particles have been used in various applications, and as a conductive paste or conductive ink for forming a wiring by, for example, screen printing, ink jet printing, or the like, a dispersion formed by dispersing fine metal particles in a medium has become known. Such a fine metal particle dispersion can be obtained by reducing oxides or salts of metals in a reaction liquid.

Recently, from the viewpoints of printability, denseness of a wiring, decrease in the sintering temperature, or the like, fine metal particles included in a conductive paste or conductive ink are required to have smaller particle diameters. Particularly, in view of application in ink for ink jet, nanoparticles having an average particle diameter of 50 nm or less are required so as to prevent a head from clogging and provide good dischargeability and storage stability of ink.

Silver particles or copper particles are used as the fine metal particles included in a conductive paste or conductive ink for wiring in many cases, but use of copper particles has attracted attention, for example, since they are less expensive. However, copper has a tendency of being easily oxidized as compared with silver, and when it is used particularly to prepare nanoparticles having a particle diameter of 100 nm or less, a problem of oxidation becomes noticeable. If the copper particles are oxidized, the dispersion stability or the conductivity is reduced when the copper particles are used to prepare a dispersion. As a result, it is preferable to improve the oxidation resistance. Further, copper nanoparticles having a small average particle diameter have problems that the interaction between the particles is strong and even though they are not oxidized, the dispersion state cannot be maintained due to the aggregation or coalescence of particles. Therefore, in order to improve the oxidation resistance or the dispersion stability, it is known that a protective agent (dispersant) may be added to the preparation of copper particles, and the surface of the copper particles are coated with the protective agent (dispersant).

WO06/019144A and JP2011-52284A describe that gelatin is used to improve the dispersion stability of copper particles or to adjust the particle diameter, but in order to further improve the performance of a conductive paste or conductive ink, there is a demand for copper nanoparticles having smaller particle diameters and having excellent oxidation resistance and dispersion stability.

Furthermore, as a method for preparing copper nanoparticles, a polyol method involving reduction in an organic solvent is known (see, for example, JP2005-330552A), or the like, but the method has, for example, a concern of ignition due to heat generation by oxidation of copper nanoparticles, and therefore, there is a demand for a method for simply preparing copper nanoparticles having excellent oxidation resistance in a safer water-based medium.

EP 2 319 643 A1 relates to a metallic copper dispersion comprising at least metallic copper particles having a gelatin on a surface thereof, a polymer dispersing agent, and an organic solvent, wherein the differences between the amine value and the acid value of the gelatin and the polymer dispersing agent are specifically adjusted.

### SUMMARY OF THE INVENTION

It is an object of the present invention to provide copper nanoparticles having an average particle diameter of 50 nm or less and having excellent oxidation resistance and dispersion stability. It is another object of the present invention to provide a method for simply preparing copper nanoparticles having an average particle diameter of 50 nm or less and having excellent oxidation resistance and dispersion stability in a water-based medium.

In order to solve the above-described problems, the present inventors have made extensive studies, in particular, on a protective agent for coating copper nanoparticles, and as a result, they have found that copper nanoparticles having an average particle diameter of 50 nm or less and having excellent dispersion stability and oxidation resistance are obtained in a water-based medium by using collagen peptides having a weight average molecular weight of 10000 or less (hereinafter also referred to as "low-molecular-weight collagen peptides"), thereby completing the present invention.

The reason why copper nanoparticles having a small particle diameter and having excellent oxidation resistance and dispersion stability through using low-molecular-weight collagen peptides are obtained is not clear, but it is presumed by the present inventors as follows.

That is, in the case of using polymers such as gelatin and polyvinylpyrrolidone (PVP) in the related art as a protective agent, the protective agent has a number of adsorption points to be adsorbed on the copper nanoparticles and has enhanced dispersion stability so as to perform the coating in the state where it is difficult for the protective agent to become free from the copper nanoparticles. However, polymers such as gelatin have low motility of a main chain, and further, the molecular chains themselves are bulky. Thus, it is difficult to increase the density of the protective agent adsorbed on the surfaces of the copper nanoparticles. As a result, even when the surface is coated with the protective agent, there is an increased tendency for oxygen molecules to be brought into contact with the surface of the copper nanoparticles, leading to oxidation of the copper nanoparticles. In addition, it is thought that in the case of using a protective agent such as a low-molecular-weight alkylamine known in the related art, the protective agent has adsorption for the coating of the copper nanoparticles and desorption from the copper nanoparticles in an equivalent state, and therefore, the dispersion stability is lowered and it is difficult to increase the oxidation resistance.

On the other hand, it is thought that in the present invention, by using collagen peptides having a weight average molecular weight of 10000 or less as a protective agent, the motility of the molecules of the protective agent is improved or the volume of the molecules is reduced to increase the density of the protective agent on the surfaces of the copper nanoparticles and thus, improve the oxidation resistance, and in addition, the adsorption points with the copper nanoparticles are secured to perform the coating in the state where it is difficult for the protective agent to become free from the copper nanoparticles, thereby improving the dispersion stability.

Specifically, the present invention is configured as follows.
[1] Collagen peptide-coated copper nanoparticles, wherein the copper nanoparticles having an average particle diameter of 50 nm or less are coated with collagen peptides having a weight average molecular weight of 10000 or less.
[2] The collagen peptide-coated copper nanoparticles as described in [1], wherein the ratio of the mass of the collagen peptide to the mass of the copper nanoparticles is from 0.05 to 0.8.
[3] The collagen peptide-coated copper nanoparticles as described in [1] or [2], wherein the ratio of the mass of the collagen peptide to the mass of the copper nanoparticles is from 0.06 to 0.6.
[4] The collagen peptide-coated copper nanoparticles as described in any one of [1] to [3], wherein the copper nanoparticles contain at least one metal selected from the group consisting of gold, silver, palladium, platinum, and nickel at a mass ratio relative to copper in the range of 0.001 to 0.1.
[5] The collagen peptide-coated copper nanoparticles as described in any one of [1] to [4], wherein the copper nanoparticles contain silver or palladium at a mass ratio relative to copper in the range of 0.001 to 0.1.
[6] The collagen peptide-coated copper nanoparticles as described in any one of [1] to [5], wherein the weight average molecular weight of the collagen peptide is from 1000 to 5000.
[7] A collagen peptide-coated copper nanoparticle dispersion formed by dispersing the collagen peptide-coated copper nanoparticles as described in any one of [1] to [6] in a medium.
[8] A method for preparing collagen peptide-coated copper nanoparticles, including reacting an oxide or salt of copper with a reducing agent in a water-based medium in the presence of a complexing agent and collagen peptides having a weight average molecular weight of 10000 or less to reduce the oxide or salt of copper, thereby preparing collagen peptide-coated copper nanoparticles, wherein the copper nanoparticles having an average particle diameter of 50 nm or less are coated with collagen peptides having a weight average molecular weight of 10000 or less.
[9] A conductive ink including the collagen peptide-coated copper nanoparticles as described in any one of [1] to [6].
[10] A method for preparing a conductive film, including applying the conductive ink as described in [9] onto a base material; and applying energy to the conductive ink to sinter the collagen peptide-coated copper nanoparticles.
[11] The method for preparing a conductive film as described in [10], wherein the applying of energy includes subjecting the conductive ink to light irradiation.
[12] The method for preparing a conductive film as described in [11], wherein the light irradiation is light irradiation by a flash lamp.
[13] The method for preparing a conductive film as described in any one of [10] to [12], wherein the applying of the conductive ink on the base material is discharging the conductive ink by an ink jet method to apply the conductive ink onto the base material.

According to the present invention, copper nanoparticles having an average particle diameter of 50 nm or less and having excellent oxidation resistance and dispersion stability can be provided. Further, according to the present invention, a method for simply preparing copper nanoparticles having an average particle diameter of 50 nm or less and having excellent oxidation resistance and dispersion stability in a water-based medium can be provided.

### BRIEF DESCRIPTION OF THE DRAWINGS

Fig. 1 is a view showing a transmission electron micrograph of copper nanoparticles having an average particle diameter of about 20 nm in Example 1.
Fig. 2 is a view showing a transmission electron micrograph of copper nanoparticles having an average particle diameter of about 30 nm in Example 6.

### DESCRIPTION OF THE PREFERRED EMBODIMENTS

Hereinbelow, the present invention will be described. In the present invention, a description of "(from) X to Y" representing a numerical range has a same meaning as "greater than or equal to X and less than or equal to Y".

The collagen peptide-coated copper nanoparticles of the present invention are nanoparticles in which copper nanoparticles having an average particle diameter of 50 nm or less are coated with collagen peptides having a weight average molecular weight of 10000 or less.

The collagen peptide-coated copper nanoparticles of the present invention refer to copper nanoparticles in which low-molecular-weight collagen peptides are adsorbed on at least a part of the surface of the copper nanoparticles having an average particle diameter of 50 nm or less. Further, in the present invention, the copper nanoparticles also include those coated with low-molecular-weight collagen peptides and one or more additional protective agents other than the collagen peptides. In addition, the coating may be carried out on a part or all of the copper nanoparticles, and preferably on all of the copper nanoparticles.

The collagen peptide-coated copper nanoparticles in the present invention are preferably prepared by reducing an oxide or salt of copper in the presence of collagen peptides having a weight average molecular weight of 10000 or less in a medium.

### [Low-Molecular-Weight Collagen Peptide]

The collagen peptides in the present invention have a weight average molecular weight of 10000 or less. In the present invention, the collagen peptides having a weight average molecular weight of 10000 or less act as a protective agent for the copper nanoparticles, and provide oxidation resistance and dispersion stability for the copper nanoparticles. It is thought that when the collagen peptides have a weight average molecular weight of 10000 or less, a balance between the oxidation resistance and the dispersion stability is excellent and copper nanoparticles having small particle diameters can be obtained.

By improving the motility of the molecules or reducing the volume of the molecules, the density on the surfaces of the copper nanoparticles increases, and the oxidation resistance is thus improved. For this reason, the weight average molecular weight of the collagen peptides is preferably 7000 or less, more preferably 6800 or less, still more preferably 5000 or less, and particularly preferably 3000 or less.

By increasing the number of adsorption points with the copper nanoparticles, coating is performed in the state where it is difficult for the collagen peptides to become free from the copper nanoparticles and the dispersion stability is improved, and for this reason, the weight average molecular weight of the collagen peptides is preferably 1000 or more, more preferably 2000 or more, and still more preferably 2700 or more.

The weight average molecular weight of the collagen peptides is determined by means of gel permeation chromatography (GPC). Hence, it calculated on the basis of a calibration curve with a relationship between retention time obtained with plural different polymers (for example polyethylene glycol: PEG) having predetermined molecular weights under the same conditions and the molecular weight. The average molecular weight in the present invention refers to a weight average molecular weight calculated by means of GPC in this method.

The collagen peptides are obtained by hydrolyzing gelatin with an enzyme, an acid, an alkali, or the like, and are proteins rich in glycine, and they may be commercially available. The method for hydrolyzing gelatin is not particularly limited, but a method known in the related art may be used.

Furthermore, the composition and number of amino acids constituting the collagen peptides are not particularly limited as long as they are within the above-described ranges of molecular weights, and examples of the collagen peptides include collagen peptides having 3 residues of amino acids (2 peptide bonds), and oligopeptides having 2 to 6 peptide bonds.

In the case where commercially available products are used as the low-molecular-weight collagen peptides in the present invention, NatiCol 1000 (manufactured by Weishardt Corporation, weight average molecular weight 2700), NatiCol 4000 (manufactured by Weishardt Corporation, weight average molecular weight 6800), or the like may be used.

In the collagen peptide-coated copper nanoparticles in the present invention, the content of the low-molecular-weight collagen peptides is preferably from 0.05 to 0.8, more preferably from 0.06 to 0.63, still more preferably from 0.06 to 0.6, particularly preferably from 0.06 to 0.315, even still more preferably from 0.06 to 0.3, and most preferably from 0.063 to 0.158, in terms of a ratio of the mass of the low-molecular-weight collagen peptides to the mass of the copper nanoparticles (mass of low-molecular-weight collagen peptides/mass of copper nanoparticles). When the mass ratio of the low-molecular-weight collagen peptides to the copper nanoparticles is 0.05 or more, it is difficult for the collagen peptide-coated copper nanoparticles to be precipitated and the dispersion stability is excellent, whereas when the mass ratio of the low-molecular-weight collagen peptides to the copper nanoparticles is 0.8 or less, the average particle diameter of the collagen peptide-coated copper nanoparticles can be lowered.

### [Copper Nanoparticles]

The copper nanoparticles with an average particle diameter of 50 nm or less, which have low-molecular-weight collagen peptides coated on the surfaces thereof, will be described.

In the present invention, the copper nanoparticles refer to nanoparticles including copper alone or nanoparticles including copper as a main component. Inclusion of copper as a main component means that among the metal components included in the copper nanoparticles, copper is included at 90% by mass or more, and the content of copper in the copper nanoparticles is preferably 95% by mass or more, and more preferably 97% by mass or more.

The copper nanoparticles according to the present invention are obtained by reducing the copper ions included in oxides or salts of copper, but depending on the kind of the copper nanoparticles to be obtained, for example, a metal compound such as an acetate, sulfate, nitrate, carbonate, chloride, bromide, hydroxide, and oxide of copper may be dissolved or dispersed in a water-based solvent or an organic solvent.

Among these, a salt or hydroxide of copper which is soluble in water may be preferably used as a raw material. Examples of such a compound include copper acetate, copper sulfate, copper chloride, and copper hydroxide. Further, a hydrate thereof (for example, copper sulfate pentahydrate) may also be included.

The average particle diameter (average primary particle diameter) of the copper nanoparticles according to the present invention is 50 nm or less, but it is preferably 40 nm or less, more preferably 30 nm or less, and still more preferably 20 nm or less, from the viewpoints of drawing properties in the preparation of a conductive ink or of lowering the sintering temperature in the formation of a wiring. Further, from the viewpoint of inhibiting the particle aggregation, the average particle diameter is preferably 1 nm or more, more preferably 3 nm or more, and still more preferably 5 nm or more.

The average particle diameter of the copper nanoparticles according to the present invention refers to an average particle diameter determined by a transmission electron microscope (TEM).

In the present invention, since the average particle diameter of the copper nanoparticles can be lowered and the oxidation resistance can also be improved, the copper nanoparticles preferably contain at least one metal selected from the group consisting of gold, silver, palladium, platinum, and nickel at a ratio mass relative to copper in the range of 0.001 to 0.1, more preferably in the range of 0.005 to 0.05, more preferably in the range of 0.01 to 0.03, and particularly preferably in the range of 0.01 to 0.02. In particular, the copper nanoparticles preferably contain silver or palladium at the above-described mass ratio relative to copper.

The copper nanoparticles may be made to contain these metals other than copper by adding an appropriate amount of an additive including an oxide or salt of the metal.

### [Collagen Peptide-Coated Copper Nanoparticles]

The collagen peptide-coated copper nanoparticles in the present invention are particles formed by coating the copper nanoparticles having an average particle diameter of 50 nm or less with the low-molecular-weight collagen peptides. In the collagen peptide-coated copper nanoparticles, it is thought that the low-molecular-weight collagen peptides are adsorbed on at least a part of the surfaces of the copper nanoparticles. It can be confirmed that the low-molecular-weight collagen peptides are coated with the copper nanoparticles by observing the copper nanoparticles by means of, for example, TEM.

### [Method for Preparing Collagen Peptide-Coated Copper Nanoparticles]

The method for preparing collagen peptide-coated copper nanoparticles in the present invention preferably includes a reduction treatment in which oxides or salts of copper are reduced in the presence of collagen peptides having a weight average molecular weight of 10000 or less in a medium.

The medium is preferably a solvent in which the low-molecular-weight collagen peptides or the oxides or salts of copper are dissolved or dispersed, and may be a water-based medium or an organic medium (for example, alcohol). However, since there is a concern of ignition due to heat generation by oxidation of the copper nanoparticles, a safer water-based medium is preferred. The water-based medium may be a solvent including water alone or a mixed solvent containing 50% by mass or less of a water-soluble solvent in addition to water.

### [Complexing Agent]

In the method for preparing collagen peptide-coated copper nanoparticles in the present invention, a complexing agent is preferably used. By using the complexing agent, an effect that particle shapes and particle diameters are more easily controlled is obtained.

The complexing agent is not limited as long as it forms a complex together with copper ions, but it is preferably one having a coordinating functional group containing an oxygen atom, a nitrogen atom, or a sulfur atom. Examples of such a functional group include a hydroxyl group, a carboxyl group, a carbonyl group, an amide group, an amino group, and a thiol group, and a hydroxyl group, a carboxyl group, an amide group, and an amino group are preferred. Further, those containing two or more kinds of the functional groups in the same molecule are also preferred.

Examples of the complexing agent include oxycarboxylic acids such as lactic acid, malic acid, tartaric acid, citric acid, and gluconic acid, or salts thereof; aminocarboxylic acids such as nitriletriacetic acid, ethylenediaminetetraacetic acid (EDTA), hydroxyethylethylene diamine triacetic acid, diethylenetriaminepentaacetic acid, triethylenetetraminehexaacetic acid, 1,3-propanediaminetetraacetic acid, hydroxyethyliminodiacetic acid, N,N-di(2-hydroxyethyl)glycine (DHEG), glycol ether diaminetetraacetic acid, asparaginic acid-diacetic acid, methylglycinediacetic acid, glutaminic acid-diacetic acid, and ethylenediaminedisuccinic acid, or salts thereof; triethanolamine, and glycerin, and tartaric acid and N,N-di(2-hydroxyethyl)glycine (DHEG) are preferred. Further, either these salts (for example, sodium tartrate) or hydrates (for example, sodium tartrate dihydrate) may be included.

The addition amount of the complexing agent is preferably from 0.5 to 2.0, more preferably from 1.0 to 1.8, and still more preferably from 1.1 to 1.5, in terms of a molar ratio relative to the oxides or salts of copper.

### [Reduction Treatment]

The reduction treatment of the copper nanoparticles is not particularly limited, but it may be carried out, for example, by adding a reducing agent. Further, it may be a reduction treatment by electrolytic reduction not using a reducing agent or the like, but it is preferably a reduction treatment using a reducing agent.

The reducing agent is not particularly limited, but examples thereof include hydrazine-based reducing agents such as hydrazine, hydrazine hydrochloride, hydrazine sulfate, and hydrazine hydrate, sodium borohydride, sodium sulfite, sodium bisulfite, sodium thiosulfate, sodium nitrite, sodium hyponitrite, phosphorous acid, sodium phosphite, hypophosphorous acid, sodium hypophosphite, aldehydes, alcohols, amines, and sugars, which may be used alone or in combination of two or more kinds thereof. As the reducing agent, a hydrazine-based reducing agent is preferred.

In order to promote the reducing action of the reducing agent, if necessary, the temperature or the pH may also be adjusted. For example, the reduction temperature is preferably from 10 to 80°C, and more preferably from 10 to 60°C. The pH is preferably from 11.5 to 14.0. In addition, the amount of the reducing agent to be used is not particularly limited as long as it is an amount suitable for reducing the copper ions, but it may be, for example, in the range of 0.2 to 5 mol with respect to 1 mol of copper contained in the oxides or salts of copper.

A known basic compound may be used to adjust the pH as described above. For example, it is preferable to use one selected from the group consisting of water-soluble alkali metal compounds, ammonia, ammonium salt compounds, and alkaline compounds formed by combination of two or more kinds thereof. Here, as the water-soluble alkali metal compounds, water-soluble alkali metal compounds from which highly basic aqueous solutions are obtained, such as alkali metal hydroxides, alkali metal carbonates, and alkali metal carbonate hydroxide salts, are suitably used.

In the case of carrying out electrolytic reduction, examples of the cathode materials may include rod-shaped or plate-shaped electrodes formed of platinum, carbon, or the like, and nanostructure electrodes such as dot electrodes, formed of platinum, carbon, or the like. Examples of the anode may include rod-shaped, plate-shaped, or net-shaped electrodes formed of carbon, platinum, or the like. In an embodiment, a rocking motion such as ultrasonic vibration may be given to the cathode in order to detach and recover the particles precipitated near the cathode surface. The current density is preferably from about 0.01 to 100 kA/dm², and more preferably from 0.1 to 50 kA/dm², and the current may be pulse current other than DC. The reduction temperature is preferably from 10 to 70°C, and more preferably from 10 to 40°C. There is a tendency that as the reduction temperature increases, the reduction reaction rate increases, whereas as the reduction temperature decreases, the particle diameters of the particles precipitated becomes smaller.

Specifically, for example, a solution containing metal ions, low-molecular-weight collagen peptides, a complexing agent, and the like in a bath having the above-described electrode is prepared, and an electrolytic reduction reaction is carried out under the above-described conditions. After completion of the reduction reaction, the copper nanoparticles that precipitate near the cathode surface are recovered.

Moreover, in the case of employing any reduction reaction, aggregation in the dendritic shape is inhibited, and fine metal particles having a narrow particle diameter distribution are easily obtained by carrying out the reaction in the presence of halogen ions. As a result, the particle diameter distribution of the copper nanoparticles can be controlled. The halogen ions are at least one selected from fluorine ions, chlorine ions, bromine ions, and iodine ions, and the ionic halides may be halogen ion sources. Specific examples thereof include hydrogen chloride, potassium chloride, sodium chloride, cuprous chloride, cupric chloride, hydrogen bromide, potassium bromide, sodium bromide, cuprous bromide, cupric bromide, hydrogen iodide, iodide potassium, sodium iodide, cuprous iodide, cupric iodide, hydrogen fluoride, potassium fluoride, sodium fluoride, cuprous fluoride, cupric fluoride, calcium chloride, barium chloride, ammonium chloride, calcium bromide, barium bromide, ammonium bromide, calcium iodide, barium iodide, ammonium iodide, and ammonium fluoride. These may be used alone or in combination of two or more kinds thereof. Among the halogen ions, chlorine ions are particularly preferred. The concentration of the halogen ions is preferably from 0.002 to 1.0 mol/liter (L). When the concentration of the halogen ions is 0.002 mol/L or more, the atoms can inhibit incorporation of the divalent or monovalent copper ionic compound, and thus such a range of concentrations is preferred. Further, when the concentration of the halogen ions is 1.0 mol/L or less, the halogen ions are easily removed, and thus the concentration is preferred. The more preferred concentration of the halogen ions is from 0.005 to 0.2 mol/L.

Furthermore, in the case of employing any reduction treatment, after the precipitation of the copper nanoparticles, ordinary treatments such as recovery, washing, and drying of the copper nanoparticles by, for example, filtration, centrifugation, decantation, or ultrafiltration, can be carried out.

The method for preparing collagen peptide-coated copper nanoparticles in the present invention is preferably a method including reacting an oxide or salt of copper with a reducing agent in a water-based medium in the presence of a complexing agent and collagen peptides having a weight average molecular weight of 10000 or less to reduce the oxides or salts of copper, thereby preparing collagen peptide-coated copper nanoparticles, in which copper nanoparticles having an average particle diameter of 50 nm or less are coated with the collagen peptides having a weight average molecular weight of 10000 or less.

By the synthesis in the manner, collagen peptide-coated copper nanoparticles having an average particle diameter of primary particles of 50 nm or less can be efficiently obtained.

In the method for preparing collagen peptide-coated copper nanoparticles in the present invention, additional components other than a complexing agent, a reducing agent, and a pH adjuster may be used. Examples of such other components include a surfactant and a defoaming agent.

### [Collagen Peptide-Coated Copper Nanoparticle Dispersion]

The collagen peptide-coated copper nanoparticle dispersion in the present invention is formed by dispersing the collagen peptide-coated copper nanoparticles in a medium.

Any medium may be used without particular limitation as long as it is a medium used in known conductive inks or conductive pastes.

As the medium, a solvent is preferred, and as the solvent, a wide range of organic solvents such as water, alcohols, ethers, and esters can be used. The medium is not particularly limited, but from the viewpoint of dispersion stability, at least one selected from the group consisting of water, aliphatic alcohols having 1 to 3 hydroxyl groups, alkyl ethers derived from the alcohols, and alkyl ethers derived from the alcohols is preferably used.

In the case where water is used as a solvent, water having a high level of purity, such as deionized water, is preferred.

Examples of the aliphatic alcohols having 1 to 3 hydroxyl groups include methanol, ethanol, 1-propanol, 1-butanol, 1-pentanol, 1-hexanol, cyclohexanol, 1-heptanol, 1-octanol, 1-nonanol, 1-decanol, glycidol, methylcyclohexanol, 2-methyl-1-butanol, 3-methyl-2-butanol, 4-methyl-2-pentanol, isopropyl alcohol, 2-ethylbutanol, 2-ethylhexanol, 2-octanol, terpineol, dihydroterpineol, 2-methoxyethanol, 2-ethoxyethanol, 2-n-butoxyethanol, 2-phenoxyethanol, carbitol, ethylcarbitol, n-butylcarbitol, diacetone alcohol, ethylene glycol, diethylene glycol, triethylene glycol, tetraethylene glycol, propylene glycol, trimethylene glycol, dipropylene glycol, tripropylene glycol, 1,2-butylene glycol, 1,3-butylene glycol, 1,4-butylene glycol, pentamethylene glycol, hexylene glycol, and glycerin.

Among these, since the aliphatic alcohols with 1 to 4 carbon atoms, having 1 to 3 hydroxyl groups, have a boiling point that is not too high and for which remaining after sintering is difficult, they are more preferred. Specifically, such aliphatic alcohols are preferably methanol, ethylene glycol, glycerin, 2-methoxyethanol, and diethylene glycol.

The ethers may be alkyl ethers derived from the alcohols, and examples thereof include diethyl ether, diisobutyl ether, dibutyl ether, methyl-t-butyl ether, methylcyclohexyl ether, diethylene glycol dimethyl ether, diethylene glycol diethyl ether, triethylene glycol dimethyl ether, triethylene glycol diethyl ether, tetrahydrofuran, tetrahydropyran, and 1,4-dioxane. Among these, alkyl ethers with 2 to 8 carbon atoms, derived from the aliphatic alcohols with 1 to 4 carbon atoms, having 1 to 3 hydroxyl groups, are preferred, and specifically, diethyl ether, diethylene glycol dimethyl ether, and tetrahydrofuran are preferred.

The esters include alkyl esters derived from alcohols, and examples thereof include methyl formate, ethyl formate, butyl formate, methyl acetate, ethyl acetate, butyl acetate, methyl propionate, ethyl propionate, butyl propionate, and γ-butyrolactone. Among these, alkyl esters with 2 to 8 carbon atoms, derived from aliphatic alcohols with 1 to 4 carbon atoms, having 1 to 3 hydroxyl groups, are preferred, and specifically, methyl formate, ethyl formate, and methyl acetate are preferred.

Among these solvents, the solvent having a boiling point which is not too high, particularly water, is preferably used as a main solvent. The main solvent is a solvent with the highest content among the solvents.

The concentration of the collagen peptide-coated copper nanoparticles in the collagen peptide-coated copper nanoparticle dispersion is preferably from 1% by mass to 70% by mass with respect to the total mass of the dispersion.

The method for dispersing the collagen peptide-coated copper nanoparticles in a medium may be carried out by a known method (for example, using an ultrasonic homogenizer) without particular limitation.

The collagen peptide-coated copper nanoparticle dispersion can be used in various applications, but can be suitably used, in particular, as a conductive ink or conductive paste or as a conductive film forming material or a conductor wiring forming material. The copper nanoparticles in the present invention have extremely small particle diameters and have excellent dispersion stability and oxidation resistance, and thus, they can be preferably used particularly as a conductive ink.

As a method for forming a wiring using a conductive ink including the collagen peptide-coated copper nanoparticle dispersion, a method is preferred in which the conductive ink is discharged by an ink jet method to be landed on a substrate or the like, and the landed ink droplets are sintered to form a wiring.

### [Method for Preparing Conductive Film]

In the present invention, a conductive ink including collagen peptide-coated copper nanoparticles is applied onto a base material, and energy is applied to at least a part of the applied conductive ink to sinter the copper nanoparticles, thereby preparing a conductive film (conductive metallic copper film).

That is, the method for preparing a conductive film of the present invention includes applying a conductive ink including the collagen peptide-coated copper nanoparticles onto a base material; and applying energy to the conductive ink to sinter the collagen peptide-coated copper nanoparticles.

### (Base Material)

In the method for preparing a conductive film of the present invention, any known base material may be used as the base material. The base material is not particularly limited, but examples thereof include one or more kinds of base materials selected from a resin, paper, glass, a silicone-based semiconductor, a compound semiconductor, a metal oxide, a metal nitride, and wood, or a complex base material formed by combination of two or more kinds of these base materials.

Specific examples of the base material include resin base materials such as a low-density polyethylene resin, a high-density polyethylene resin, an ABS resin (acrylonitrile-butadiene-styrene copolymerization synthetic resin), an acryl resin, a styrene resin, a vinyl chloride resin, a polyester resin (preferably polyethylene terephthalate (PET)), a polyacetal resin, a polysulfone resin, a polyetherimide resin, a polyether ketone resin, and a cellulose derivative; paper base materials such as non-coated printing paper, finely coated printing paper, coated printing paper (art paper and coat paper), special printing paper, copy paper (paper for PPC), unbleached wrapping paper (heavy duty sack kraft paper and duty sack kraft paper), bleached wrapping paper (bleached kraft paper and white roll paper), court ball, tip ball, and corrugated paper; glass base materials such as soda glass, borosilicate glass, silica glass, and quartz glass; silicon-based semiconductors such as amorphous silicon and polysilicone; compound semiconductors such as CdS, CdTe, and GaAs; metal base materials such as a copper plate, an iron plate, and an aluminum plate; alumina, sapphire, zirconia, titania, yttrium oxide, indium oxide, ITO (indium tin oxide), IZO (indium zinc oxide), NESA (tin oxide), ATO (antimony-doped tin oxide), fluorine-doped tin oxide, zinc oxide, AZO (aluminum-doped zinc oxide), gallium-doped zinc oxide, and aluminum nitride base materials, or inorganic base materials such as silicon carbide; and composite base materials including paper-resin composites such as paper-phenolic resins, paper-epoxy resins, and paper-polyester resins, and glass-resin composites such as glass cloth-epoxy resins, glass cloth-polyimide resins, and glass cloth-fluorine resins. Among these, polyester resins, polyetherimide resins, paper base materials, and glass base materials are preferably used.

### (Application of Conductive Ink onto Base Material)

In the method for preparing a conductive film of the present invention, as the method for applying a conductive ink onto a base material, a coating method is preferred. The coating method is not particularly limited, but examples thereof include a screen printing method, a dip coating method, a spray coating method, a spin coating method, an ink jet method, and a coating method in a dispenser, with the ink jet method being preferred from the viewpoint of on-demand properties. The shape to be coated may be a planar shape or a dot shape, and is not particularly limited. The amount of the conductive ink to be coated on the base material may be suitably adjusted depending on a desired film thickness of the conductive film, but it may be usually coated so as to adjust the film thickness of the liquid composition after the drying to a range of 0.01 to 5000 µm, and preferably 0.1 to 1000 µm.

### (Drying)

In the method for preparing a conductive film of the present invention, it is preferable that drying of the conductive ink be carried out after applying the conductive ink on the base material so as not to make the liquid components remain before sintering. When the liquid components do not remain, there is no case where the liquid components are vaporized and expanded in the sintering to generate small cracks or voids. Thus, no residue of the liquid components is preferred from the viewpoints of adhesion of the conductive film with the base material and conductivity.

For the drying method, a hot air dryer or the like may be used, and the method is carried out at a temperature of preferably 40°C to 200°C, and more preferably 50°C to 150°C.

### (Application of Energy)

In the method for preparing a conductive film of the present invention, the collagen peptide-coated copper nanoparticles in the conductive ink are fused to give a metallic copper film, by applying energy to the conductive film that is applied on the base material and if necessary, dried (copper film before sintering).

A means for applying the energy is not particularly limited, but any method known in the related art may be used. Examples thereof include methods using electromagnetic waves such as an electric furnace and microwaves, infrared rays, a hot plate, laser beam, electron beam, ion beam, and heat rays. For the applying of energy, the energy is preferably applied by heating or light irradiation (that is, heating sintering or light sintering is preferred), and more preferably by light irradiation. Further, a combination of heating and light irradiation may be used.

By applying energy by light irradiation, sintering may be completed in a shorter time and the productivity is improved. Further, deterioration of a substrate due to heating over a long period can be inhibited, and thus, the adhesion between the metal film and the base material is improved.

The heating temperature in the case of heating sintering is preferably from 100°C to 350°C, and more preferably from 200°C to 350°C, from the viewpoint of inhibition of deterioration of a support due to heating.

Examples of the light source used in the light irradiation include a mercury lamp, a metal halide lamp, a xenon lamp, a chemical lamp, and a carbon arc lamp. Examples of the radioactive rays include an electron beam, X rays, an ion beam, and far-infrared rays. In addition, g rays, i rays, deep-UV light, and a high-density energy beam (laser beam) are also used.

In specific embodiments, scanning exposure by infrared laser, high-intensity flash exposure using a xenon discharge lamp or the like, infrared lamp exposure, and the like may be suitably mentioned.

The light irradiation is preferably light irradiation by a flash lamp, and more preferably pulse light irradiation by a flash lamp since irradiation with pulse light at high energy can heat intensively the surface of the part on which the conductive ink has been applied in an extremely short time and the effect of heat on the base material can be extremely reduced.

The pulse width is preferably from 1 microsecond to 100 milliseconds.

The irradiation time of the pulse light is preferably from 1 to 100 mseconds, more preferably from 1 to 50 mseconds, and still more preferably from 1 to 20 mseconds. The light irradiation energy is preferably from 1 to 30 J/cm², more preferably from 3 to 25 J/cm², and more preferably from 5 to 20 J/cm².

### <Conductor Wiring >

The conductive ink comprising the collagen peptide-coated copper nanoparticles according to the present invention can be used to form a conductor wiring.

The conductor wiring can be obtained by a method for printing the liquid composition patternwise or a method for etching a metal film obtained from the conductive ink patternwise.

### (Etching)

The present process involves etching the metal film patternwise. That is, in the present process, a desired metal pattern can be formed by removing unwanted parts of the metal film formed on the whole surface of the base material by etching.

In the formation of the metal pattern, any method may be used, and specifically, usually known methods such as a subtractive method and a semi-additive method are used.

The subtractive method is a method including providing a dry film resist layer on the metal film formed, forming the same pattern as the metal pattern portion by pattern exposure and development, and removing the metal film with an etching liquid using the dry film resist pattern as a mask, thereby forming a metal pattern. As the dry film resist, any material may be used, and any of materials in negative, positive, liquid, and film shapes can be used. Further, as the etching method, any of the methods used for the preparation of a print wiring substrate, for example, wet type etching and dry type etching may be used, from which any one may be arbitrarily selected. In terms of working operations, wet type etching is preferred from the viewpoint of simplicity of equipment devices. As the etching liquid, an aqueous solution of cupric chloride, ferric chloride, or the like may be used.

Furthermore, the semi-additive method is a method including providing a dry film resist layer on the metal film formed, forming the same pattern as the non-metal pattern portion by pattern exposure and development, carrying out electroplating using the dry film resist pattern as a mask, removing the dry film resist pattern, carrying out quick etching, and removing the metal film patternwise, thereby forming a metal pattern. As the dry film resist, the etching liquid, and the like, the same materials as for the subtractive method may be used, respectively. Further, as the electroplating method, the above-described method may be used.

By carrying out the above-described processes, a conductor wiring having a desired metal pattern is prepared.

On the other hand, a conductor wiring can also be prepared by forming the conductive ink patternwise, applying energy to the patterned conductive ink, and carrying out sintering.

Specifically, a conductor may be provided, for example, by discharging the conductive ink patternwise onto a base material in an ink jet system, and applying energy to a molded portion of the liquid composition.

The conductor wiring has a dense and fine structure having little void as in the metal film that can be obtained by the method for preparing a conductive film in accordance with the present invention, and thus, has good conductivity. Further, by carrying out sintering in the above-described light irradiation, a conductor wiring having high adhesion to abase material is provided.

In the case where the conductor wiring may be constituted with a multilayer wiring substrate, an insulating layer (an insulting resin layer, an interlayer insulating film, and a solder resist) is further laminated on the surface of the metal pattern material to form a new wiring (metal pattern) on the surface.

### [Examples]

The present invention will be described with reference to Examples in more detail, but is not limited thereto.

### (Example 1)

2.5 g of copper sulfate pentahydrate (manufactured by Wako Pure Chemical Industries, Ltd.) as a copper raw material, 27 mg of palladium acetate (manufactured by Wako Pure Chemical Industries, Ltd.) as an additive, 2.3 g of sodium tartrate dihydrate (manufactured by Wako Pure Chemical Industries, Ltd.) as a complexing agent, 0.1 g of Olfine E1010 (manufactured by Nissin Chemical, an acetylene-based surfactant), 3.0 g of sodium hydroxide, 40 mg of NatiCol 1000 (manufactured by Weishardt Corporation, collagen peptides having a weight average molecular weight of 2700) as a protective agent, and 200 mL of pure water were placed in a 500-ml three-necked flask equipped with a stirrer and a condenser tube, and the mixture was stirred at room temperature for 30 minutes. Then, the temperature inside the reaction vessel was set to 45°C. An aqueous solution obtained by dissolving 1.0 g of hydrazine hydrate as a reducing agent in 49 g of water was added dropwise to the reaction vessel, and the reaction was carried out for an additional 2 hours.

In this manner, collagen peptide-coated copper nanoparticles of Example 1 (hereinafter simply referred to as "copper nanoparticles" in some cases) were obtained.

The production of copper nanoparticles was confirmed by electron diffraction. From the electron diffraction patterns of the synthesized copper nanoparticles, it could be confirmed that the copper nanoparticles are those having a crystal structure Cu-fcc (face centered cubic).

An average particle diameter was determined by measuring the particle diameters of 400 primary particles randomly selected through TEM observation of the obtained copper nanoparticles. The average particle diameter of the copper nanoparticles obtained in Example 1 was about 20 nm. The results are shown in Table 1.

Furthermore, the mass ratio of the protective agent relative to the copper nanoparticles, and the mass ratio of the metals in the additive relative to copper are shown in Table 1.

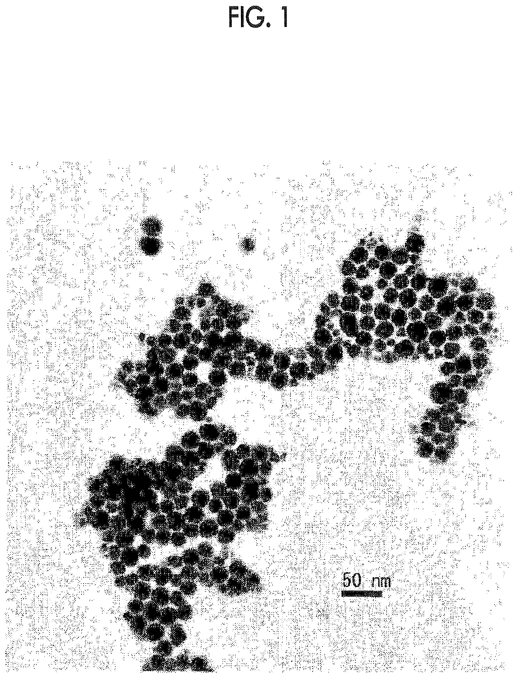

A view of the transmission electron micrograph of the copper nanoparticles having an average particle diameter of about 20 nm in Example 1 is shown in Fig. 1.

### (Examples 2 to 9)

By the same method as in Example 1 except that the copper raw materials, the complexing agents, the protective agents, and the additives to be used, and the proportions thereof were changed as shown in Table 1, collagen peptide-coated copper nanoparticles were synthesized. In Examples 2 to 9, the amounts of the copper to be used were all set to 10 mmol.

In Table 1, NatiCol 4000 is a collagen peptide having a weight average molecular weight of 6800 manufactured by Weishardt Corporation; copper hydroxide manufactured by Kanto Chemical Co., Inc. was used; N,N-di(2-hydroxyethyl)glycine (DHEG) manufactured by Tokyo Kasei Kogyo Co., Ltd. was used; and silver acetate manufactured by Wako Pure Chemical Industries, Ltd. was used.

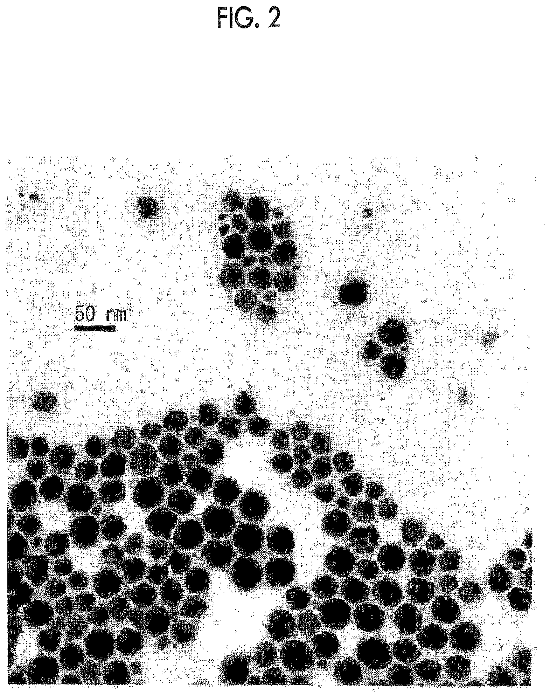

A view of the transmission electron micrograph of the copper nanoparticles having an average particle diameter of about 30 nm in Example 6 is shown in Fig. 2.

### (Comparative Example 1)

By the same method as in Example 1 except that polyethyleneimine (manufactured by Wako Pure Chemical Industries, Ltd., a weight average molecular weight of about 1800) was used as a protective agent, copper particles were synthesized.

### (Comparative Example 2)

By the same method as in Example 1 except that polyvinylpyrrolidone (manufactured by Sigma-Aldrich Corporation, a weight average molecular weight of about 8000) was used as a protective agent, copper particles were synthesized.

### (Comparative Example 3)

By the same method as in Example 1 except that gelatin (manufactured by Nitta Gelatin Ltd., an average molecular weight of about 20000) was used as a protective agent, copper particles were synthesized.

### [Evaluation]

### (Average Particle Diameter of Copper Nanoparticles)

The average particle diameter was determined by measuring the particle diameters of 400 primary particles randomly selected through TEM observation of the obtained copper nanoparticles.

Further, in a case where the primary particles could not be confirmed through TEM due to coalescence of the particles, the average particle diameter was denoted as "Not Measured".

The dispersion stability and the oxidation resistance of the copper nanoparticles were evaluated by the method below. The results are shown in Table 1.

### (Dispersion Stability)

The obtained copper nanoparticles were diluted with water to a concentration of the copper nanoparticles of about 0.25% by mass, and then 10 mL of a dispersion was measured out in a 15-mL glass bottle and stored at room temperature under atmosphere. Thus, the copper nanoparticles were left to stand over time at room temperature and occurrence of precipitation was observed.
A: After standing one week at room temperature, the precipitates were substantially not observed.
B: After standing one week at room temperature, the precipitates were observed, but were easily redispersed by stirring.
C: After standing one week at room temperature, the precipitates were observed, and were not redispersed even by stirring.
D: After standing one week at room temperature, the solid contents were completely precipitated, and thus, were not able to reach the dispersion state even by stirring.

### (Oxidation Resistance)

The obtained copper nanoparticles were diluted with water to a concentration of the copper nanoparticles of about 0.25% by mass, and then 10 mL of a dispersion was measured out in a 15-mL glass bottle and stored at room temperature under atmosphere. Thus, the copper nanoparticles were left to stand for a long period of time at room temperature and oxidation resistance was evaluated. The oxidation resistance was confirmed by first observing the change in unique color derived from plasmon absorption of the copper nanoparticle dispersion, and confirming by X ray diffraction.
A: Even after standing at room temperature for 2 weeks, no change in the color of the dispersion was seen and copper oxide was not confirmed by X ray diffraction.
B: After standing at room temperature for 1 week, no change in the color of the dispersion was seen and copper oxide was not confirmed in the X ray diffraction, but after standing for 2 weeks, copper oxide could be confirmed by X ray diffraction.
C: Within 1 week after standing at room temperature, the dispersion turned blackish blue and copper oxide was confirmed by X ray diffraction.

Not Evaluated: Since agglomeration of copper is generated and copper cannot be nanoparticulated, thus copper nanoparticles cannot be obtained and the oxidation resistance of the copper nanoparticles cannot be evaluated.

**[Table 1]**

| | Copper raw material | Protective agent | Protective agent/copper mass ratio | Complexing agent | Additive | X/Cu mass ratio (X is a metal in an additive) | Average particle diameter of copper nanoparticles | Dispersion stability | Oxidation resistance |
|---|---|---|---|---|---|---|---|---|---|
| Example 1 | Copper sulfate pentahydrate | NatiCol 1000 | 0.063 | Sodium tartrate | Palladium acetate | 0.02 | about 20 nm | A | A |
| Example 2 | Copper sulfate pentahydrate | NatiCol 1000 | 0.158 | Sodium tartrate | Palladium acetate | 0.02 | about 25 nm | A | A |
| Example 3 | Copper sulfate pentahydrate | NatiCol 1000 | 0.63 | Sodium tartrate | Palladium acetate | 0.02 | about 40 nm | B | A |
| Example 4 | Copper sulfate pentahydrate | NatiCol 1000 | 0.063 | DHEG | Palladium acetate | 0.02 | about 15 nm | A | A |
| Example 5 | Copper sulfate pentahydrate | NatiCol 1000 | 0.315 | DHEG | Palladium acetate | 0.05 | about 40 nm | B | A |
| Example 6 | Copper sulfate pentahydrate | NatiCol 1000 | 0.315 | DHEG | Palladium acetate | 0.01 | about 30 nm | B | A |
| Example 7 | Copper hydroxide | NatiCol 1000 | 0.315 | Sodium tartrate | Palladium acetate | 0.02 | about 35 nm | B | A |
| Example 8 | Copper hydroxide | NatiCol 1000 | 0.158 | Sodium tartrate | Silver acetate | 0.02 | about 45 nm | B | A |
| Example 9 | Copper sulfate pentahydrate | NatiCol 4000 | 0.315 | DHEG | Palladium acetate | 0.02 | about 40 nm | B | B |
| Comparative Example 1 | Copper sulfate pentahydrate | Polyethylenei mine | 0.63 | Sodium tartrate | Palladium acetate | 0.02 | Not measured | D | Not measured |
| Comparative Example 2 | Copper sulfate pentahydrate | Polyvinylpyrr olidone | 0.63 | Sodium tartrate | Palladium acetate | 0.02 | Not measured | D | Not measured |
| Comparative Example 3 | Copper sulfate pentahydrate | Gelatin | 0.63 | Sodium tartrate | Palladium acetate | 0.02 | about 40 nm | C | C |

Any of the collagen peptide-coated copper nanoparticle dispersions of Examples in which collagen peptides having a weight average molecular weight of 10000 or less are used as a protective agent could form dispersions that were stable at room temperature for at least one week. Further, the dispersions did not show a change in color over time and oxidation of the copper nanoparticles was not confirmed by X ray diffraction. On the other hand, in Comparative Examples 1 and 2 in which polyethyleneimine or polyvinylpyrrolidone was used as a protective agent, the colorable solid contents precipitated rapidly after reduction, and accordingly, a stable copper nanoparticle dispersion could not be obtained.

Furthermore, when gelatin having a weight average molecular weight of about 20000 was used, a copper nanoparticle dispersion could be obtained, but the copper nanoparticles were relatively easily oxidized over time at room temperature and precipitates were found. The precipitates were not redispersed even by stirring.

### (Example 10)

20 g of the collagen peptide-coated copper nanoparticles obtained in Example 1, 64 g of pure water, 10 g of ethylene glycol, and 6 g of glycerin were mixed and treated with an ultrasonic wave homogenizer for 15 minutes to obtain a collagen peptide-coated copper nanoparticle dispersion. This collagen peptide-coated copper nanoparticle dispersion was used as a conductive ink.

### (Applying onto Substrate and Drying)

On a slide glass (with Pre-cleaned Waterglass Slide with Polished Edges) (manufactured by Matsunami Glass Ind., Ltd.), the collagen peptide-coated copper nanoparticle dispersion was printed by an ink jet (IJ) printing device (DMP2831 (manufactured by Fujifilm Dimatix, Inc.)) in a 1cm ×1cm planar shape, and dried in a hot air drier at 120°C for 30 minutes to prepare a slide glass having the copper film before sintering. The film thickness of the copper film after drying and before sintering was 0.8 µm as measured with a laser microscope.

### (Sintering by Heating)

The slide glass having the copper film before sintering was heated on a hot plate under a nitrogen atmosphere to obtain a metallic copper film. The heating temperature was 300°C and the heating time was 1 hour. Further, the oxygen concentration was 100 ppm.

### (Volume Resistivity)

The surface resistance value of the metallic copper film was measured with a 4-pin method using LORESTA EP MCP-T360 (manufactured by Mitsubishi Chemical Corporation analytic Tech). A volume resistivity was calculated by multiplying the obtained surface resistance value by the film thickness.

The volume resistance value was 8×10⁻⁴ Ωcm.

### (Example 11)

In the similar manner as in Example 10, the collagen peptide-coated copper nanoparticle dispersion formed by using the collagen peptide-coated copper nanoparticles obtained in Example 1 was coated on slide glass with an ink jet (IJ) printing device, and dried in a hot air dryer to obtain a copper film before sintering.

### (Sintering by Light Irradiation)

The copper film before sintering was irradiated with an Xe flash lamp (Sinteron 2000 (manufactured by Xenon), a set voltage of 3 kV, an irradiation energy of 7 J/cm², and a pulse width of 2 msec.), and sintered to obtain a metallic copper film.

### (Volume Resistivity)

The surface resistance value of the metallic copper film was measured with a 4-pin method using LORESTA EP MCP-T360 (manufactured by Mitsubishi Chemical Corporation analytic Tech). A volume resistivity was calculated by multiplying the obtained surface resistance value by the film thickness.

The volume resistance value was 2×10⁻⁴ Ωcm.

### (Example 12)

In the same manner as in Example 11 except that as a PET substrate (manufactured by Higashiyama Film Co., Ltd.) was used instead of slide glass as a substrate, coating, drying, and light irradiation were carried out to obtain a metallic copper film. The volume resistance value was 6×10⁻⁴ Ωcm.

## Claims

1. Collagen peptide-coated copper nanoparticles, wherein the copper nanoparticles having an average particle diameter, determined by a transmission electron microscope, of 50 nm or less are coated with collagen peptides having a weight average molecular, determined by means of gel permeation chromatography, of 10000 or less.

2. The collagen peptide-coated copper nanoparticles according to claim 1, wherein the ratio of the mass of the collagen peptide to the mass of the copper nanoparticles is from 0.05 to 0.8.

3. The collagen peptide-coated copper nanoparticles according to claim 1 or 2, wherein the ratio of the mass of the collagen peptide to the mass of the copper nanoparticles is from 0.06 to 0.6.

4. The collagen peptide-coated copper nanoparticles according to any one of claims 1 to 3, wherein the copper nanoparticles contain at least one metal selected from the group consisting of gold, silver, palladium, platinum, and nickel at a mass ratio relative to copper in the range of 0.001 to 0.1.

5. The collagen peptide-coated copper nanoparticles according to any one of claims 1 to 4, wherein the copper nanoparticles contain silver or palladium at a mass ratio relative to copper in the range of 0.001 to 0.1.

6. The collagen peptide-coated copper nanoparticles according to any one of claims 1 to 5, wherein the weight average molecular weight of the collagen peptide is from 1000 to 5000.

7. A collagen peptide-coated copper nanoparticle dispersion comprising the collagen peptide-coated copper nanoparticles according to any one of claims 1 to 6 dispersed in a medium.

8. A method for preparing collagen peptide-coated copper nanoparticles, comprising reacting an oxide or salt of copper with a reducing agent in a water-based medium in the presence of a complexing agent and collagen peptides having a weight average molecular weight of 10000 or less to reduce the oxide or salt of copper, thereby preparing collagen peptide-coated copper nanoparticles, wherein the copper nanoparticles having an average particle diameter, determined by a transmission electron microscope, of 50 nm or less are coated with collagen peptides having a weight average molecular weight of 10000 or less, the weight average molecular weight of the collagen peptides being determined by means of gel permeation chromatography.

9. A conductive ink comprising the collagen peptide-coated copper nanoparticles according to any one of claims 1 to 6.

10. A method for preparing a conductive film, comprising:
applying the conductive ink according to claim 9 onto a base material; and
applying energy to the conductive ink to sinter the collagen peptide-coated copper nanoparticles.

11. The method for preparing a conductive film according to claim 10, wherein the applying of energy includes subjecting the conductive ink to light irradiation.

12. The method for preparing a conductive film according to claim 11, wherein the light irradiation is light irradiation by a flash lamp.

13. The method for preparing a conductive film according to any one of claims 10 to 12, wherein the applying of the conductive ink on the base material is discharging the conductive ink by an ink jet method to apply the conductive ink onto the base material.

## Patentansprüche

1. Kollagenpeptid-beschichtete Kupfer-Nanopartikel, worin die Kupfer-Nanopartikel, die einen mittleren Partikeldurchmesser, bestimmt mit einem Transmissionselektronenmikroskop, von 50 nm oder kleiner aufweisen, mit Kollagenpeptiden mit einem gewichtsgemittelten Molekulargewicht, bestimmt mittels Gelpermeationschromatographie, von 10.000 oder kleiner beschichtet sind.

2. Kollagenpeptid-beschichtete Kupfer-Nanopartikel gemäß Anspruch 1, worin das Verhältnis der Masse des Kollagenpeptids zur Masse der Kupfer-Nanopartikel von 0,05 bis 0,8 beträgt.

3. Kollagenpeptid-beschichtete Kupfer-Nanopartikel gemäß Anspruch 1 oder 2, worin das Verhältnis der Masse des Kollagenpeptids zur Masse der Kupfer-Nanopartikel von 0,06 bis 0,6 beträgt.

4. Kollagenpeptid-beschichtete Kupfer-Nanopartikel gemäß irgendeinem der Ansprüche 1 bis 3, worin die Kupfer-Nanopartikel mindestens ein Metall enthalten, ausgewählt aus der Gruppe bestehend aus Gold, Silber, Palladium, Platin und Nickel, in einem Masseverhältnis, relativ zu Kupfer, im Bereich von 0,001 bis 0,1.

5. Kollagenpeptid-beschichtete Kupfer-Nanopartikel gemäß irgendeinem der Ansprüche 1 bis 4, worin die Kupfer-Nanopartikel Silber oder Palladium in einem Masseverhältnis, relativ zu Kupfer, im Bereich von 0,001 bis 0,1 enthalten.

6. Kollagenpeptid-beschichtete Kupfer-Nanopartikel gemäß irgendeinem der Ansprüche 1 bis 5, worin das gewichtsgemittelte Molekulargewicht des Kollagenpeptids von 1.000 bis 5.000 beträgt.

7. Dispersion von Kollagenpeptid-beschichteten Kupfer-Nanopartikeln, umfassend die Kollagenpeptidbeschichteten Kupfer-Nanopartikel gemäß irgendeinem der Ansprüche 1 bis 6, dispergiert in einem Medium.

8. Verfahren zur Herstellung von Kollagenpeptidbeschichteten Kupfer-Nanopartikeln, umfassend das Umsetzen eines Oxids oder Salzes von Kupfer mit einem Reduktionsmittel in einem auf Wasser basierenden Medium in der Gegenwart eines Komplexiermittels und von Kollagenpeptiden mit einem gewichtsgemittelten Molekulargewicht von 10.000 oder kleiner, um das Oxid oder das Salz von Kupfer zu reduzieren, wodurch Kollagenpeptid-beschichtete Kupfer-Nanopartikel hergestellt werden, worin die Kupfer-Nanopartikel einen mittleren Partikeldurchmesser, bestimmt mit einem Transmissionselektronenmikroskop von 50 nm oder kleiner, aufweisen und mit Kollagenpeptiden mit einem gewichtsgemittelten Molekulargewicht von 10.000 oder kleiner beschichtet sind, worin das gewichtsgemittelte Molekulargewicht der Kollagenpeptide mittels Gelpermeationschromatographie bestimmt wird.

9. Leitfähige Tinte, umfassend die Kollagenpeptidbeschichteten Kupfer-Nanopartikel gemäß irgendeinem der Ansprüche 1 bis 6.

10. Verfahren zur Herstellung eines leitfähigen Films, umfassend:
Auftragen der leitfähigen Tinte gemäß Anspruch 9 auf ein Basismaterial; und
Anwenden von Energie auf die leitfähige Tinte, um die Kollagenpeptid-beschichten Kupfer-Nanopartikel zu sintern.

11. Verfahren zur Herstellung eines leitfähigen Films gemäß Anspruch 10, worin das Anwenden von Energie das Unterziehen der leitfähigen Tinte unter eine Belichtung umfasst.

12. Verfahren zur Herstellung eines leitfähigen Films gemäß Anspruch 11, worin die Belichtung eine Belichtung mit einer Blitzlampe ist.

13. Verfahren zur Herstellung eines leitfähigen Films gemäß irgendeinem der Ansprüche 10 bis 12, worin das Auftragen der leitfähigen Tinte auf das Basismaterial ein Ausstoßen der leitfähigen Tinte durch ein Tintenstrahlverfahren ist, um die leitfähige Tinte auf das Basismaterial aufzutragen.

## Revendications

1. Nanoparticules de cuivre enrobées de peptide de collagène, dans lesquelles les nanoparticules de cuivre ayant un diamètre particulaire moyen, déterminé par un microscope électronique à transmission, de 50 nm ou moins sont enrobées par des peptides de collagène ayant un poids moléculaire moyen pondéral, déterminé au moyen d'une chromatographie par perméation sur gel, de 10 000 ou moins.

2. Nanoparticules de cuivre enrobées de peptide de collagène selon la revendication 1, dans lesquelles le rapport de la masse du peptide de collagène sur la masse des nanoparticules de cuivre est de 0,05 à 0,8.

3. Nanoparticules de cuivre enrobées de peptide de collagène selon la revendication 1 ou 2, dans lesquelles le rapport de la masse du peptide de collagène sur la masse des nanoparticules de cuivre est de 0,06 à 0,6.

4. Nanoparticules de cuivre enrobées de peptide de collagène selon l'une quelconque des revendications 1 à 3, dans lesquelles les nanoparticules de cuivre contiennent au moins un métal sélectionné dans le groupe constitué de l'or, de l'argent, du palladium, du platine, et du nickel à un rapport en masse par rapport au cuivre situé dans la plage allant de 0,001 à 0,1.

5. Nanoparticules de cuivre enrobées de peptide de collagène selon l'une quelconque des revendications 1 à 4, dans lesquelles les nanoparticules de cuivre contiennent de l'argent ou du palladium à un rapport en masse par rapport au cuivre situé dans la plage allant de 0,001 à 0,1.

6. Nanoparticules de cuivre enrobées de peptides de collagène selon l'une quelconque des revendications 1 à 5, dans lesquelles le poids moléculaire moyen pondéral du peptide de collagène est de 1000 à 5 000.

7. Dispersion de nanoparticules de cuivre enrobées de peptide de collagène comprenant les nanoparticules de cuivre enrobées de peptide de collagène selon l'une quelconque des revendications 1 à 6 dispersées dans un milieu.

8. Procédé de préparation de nanoparticules de cuivre enrobées de peptide de collagène, comprenant la réaction d'un oxyde ou d'un sel de cuivre avec un agent réducteur dans un milieu à base d'eau en présence d'un agent complexant et de peptides de collagène ayant un poids moléculaire moyen pondéral de 10 000 ou moins pour réduire l'oxyde ou le sel de cuivre, pour ainsi préparer des nanoparticules de cuivre enrobées de peptide de collagène, dans lequel les nanoparticules de cuivre ayant un diamètre particulaire moyen, déterminé par un microscope électronique à transmission, de 50 nm ou moins sont enrobées par des peptides de collagène ayant un poids moléculaire moyen pondéral de 10 000 ou moins, le poids moléculaire moyen pondéral des peptides de collagène étant déterminé au moyen d'une chromatographie par perméation sur gel.

9. Encre conductrice comprenant les nanoparticules de cuivre enrobées de peptide de collagène selon l'une quelconque des revendications 1 à 6.

10. Procédé de préparation d'un film conducteur, comprenant :
l'application de l'encre conductrice selon la revendication 9 sur un matériau de base ; et
l'application d'énergie à l'encre conductrice pour fritter les nanoparticules de cuivre enrobées de peptide de collagène.

11. Procédé de préparation d'un film conducteur selon la revendication 10, dans lequel l'application d'énergie comprend la soumission de l'encre conductrice à une irradiation lumineuse.

12. Procédé de préparation d'un film conducteur selon la revendication 11, dans lequel l'irradiation lumineuse est une irradiation lumineuse par une lampe éclair.

13. Procédé de préparation d'un film conducteur selon l'une quelconque des revendications 10 à 12, dans lequel l'application de l'encre conductrice sur le matériau de base est le déchargement de l'encre conductrice par un procédé à jet d'encre pour appliquer l'encre conductrice sur le matériau de base.
